# EUROPÄISCHE PATENTSCHRIFT

(11) **EP 2 704 212 B1**
(45) Veröffentlichungstag und Bekanntmachung des Hinweises auf die Patenterteilung: **05.07.2017**
(21) Anmeldenummer: 13179311.9
(22) Anmeldetag: 05.08.2013
(51) Int. Cl.: H01L 31/05, H01L 31/18

(54) **Verfahren und Vorrichtung zum Herstellen von Solarzellen-Strings**
Method and device for producing solar cell strings
Procédé et dispositif de fabrication de chaînes de cellules solaires

(30) Priorität: 31.08.2012 US 201213600566
(43) Veröffentlichungstag der Anmeldung: 05.03.2014
(73) Patentinhaber: Komax Holding AG, 6036 Dierikon (CH)
(72) Erfinder: Duncan, William D., Elizabethtown, PA 17022 (US); Gretler, Adrian, PA 17313 Dallastown (US); Lyon, James R., PA 17319 Etters (US); Dingle, Brad, Red Lion, PA Pennsylvania 17356 (US)
(74) Vertreter: Inventio AG

(56) Entgegenhaltungen:
- EP-A1- 1 748 495
- EP-A1- 2 439 782
- WO-A2-2012/016103
- JP-A- 2011 187 601
- US-A1- 2006 219 352
- US-A1- 2012 042 925
- US-B2- 6 841 728

## Beschreibung

Die vorliegende Erfindung betrifft ein Verfahren und eine Vorrichtung zum Herstellen von Solarzellen-Strings. Derartige Solarzellen-Strings bestehen aus aneinander gereihten Solarzelle, die durch elektrische Leiter (z. B. Leiterbänder, engl. "ribbons") miteinander verbunden sind oder werden.

Zur Herstellung von kristallinen Photovoltaik-Modulen müssen Solarzellen elektrisch miteinander verbunden werden. Im als Strangbildung (engl.: stringing) bekannten Prozess, werden Solarzellen beispielsweise mittels einer Pick-and-Place-Einrichtung aneinandergereiht und die Solarzellen elektrisch miteinander verbunden, wodurch "Stränge" von Solarzellen gebildet werden. Als Leiter werden häufig elektrisch leitfähige Leiterbänder verwendet. Diese können dünne, flache Streifen aus Kupfer sein. Die Rückseite einer Solarzelle wird mit der Vorderseite der nächsten bzw. nachfolgenden Solarzelle durch elektrische Kontaktierung mittels der erwähnten Leiterbänder elektrisch verbunden. Die jeweiligen elektrischen Kontakte werden schliesslich in einem Lötvorgang oder einem anderen Verbindungsverfahren fertiggestellt. Verfahren und Vorrichtungen zum Herstellen von Solarzellen-Strings sind beispielsweise aus US 2010/7038358, US 2006/219352 und US 6,510,940 bekannt geworden.

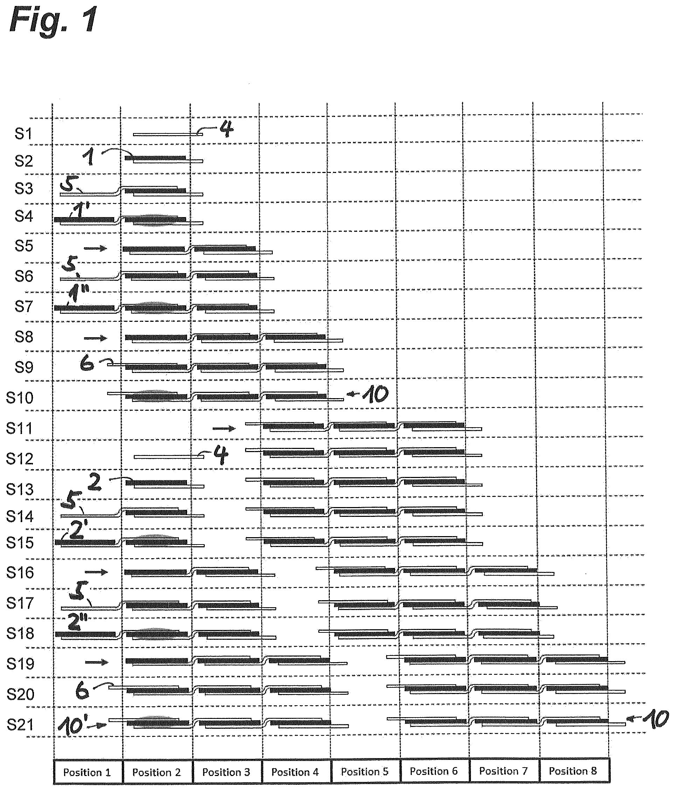

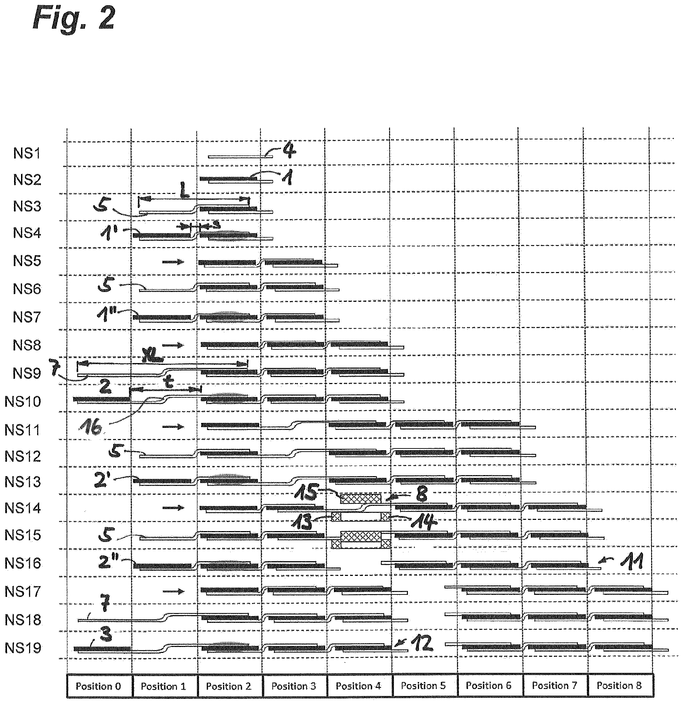

Figur 1 zeigt in einer schematischen Darstellung die einzelnen Schritte eines Verfahrens zur Herstellung von Solarzellen-Strings, wie es zurzeit bekannt und gebräuchlich ist. Zunächst wird ein Anfangs-Leiterstück 4 bereitgestellt (Schritt S1), worauf eine erste Solarzelle 1 platziert wird (Schritt S2). Nun kommen Leiterbänder zum Verbinden benachbarter Solarzellen zum Einsatz. Diese Leiterbänder sind in Figur 1 (sowie auch in nachfolgender Fig. 2) mit "5" bezeichnet. In einem dritten Arbeitsschritt S3 wird ein solches Leiterband 5 auf die erste Solarzelle 1 abgelegt. Danach wird eine zweite Solarzelle 1' auf den hinteren Teil des Leiterbandes 5 platziert (Schritt S4). Ersichtlicherweise verbindet dieses Leiterband eine Vorderseite der ersten Solarzelle 1 mit der Rückseite der zweiten Solarzelle 1'. Simultan mit dem Platzieren der zweiten Solarzelle 1' wird die erste Solarzelle 1 mit dem Anfangs-Leiterstück 4 in einem Löt- oder ein anderen Verbindungsverfahren unter Verwendung einer Kontaktierungs-Einrichtung elektrisch verbunden. Das so hergestellte Gebilde wird dann um eine an die Solarzelle angepasste Position unter Verwendung eines (nicht dargestellten) Fördermittels um eine Position verschoben (Schritt S5). Ein zweites Leiterband 5 kann dann auf der zweiten Solarzelle 1' abgelegt werden (S6), dann wird eine dritte Solarzelle 1" auf dem zweiten Leiterband 5 platziert (Schritt S7). Nachdem das nun drei Solarzellen umfassende Gebilde um eine weitere Position verschoben wurde (Schritt S8), wird ein End-Leiterband 6 auf die dritte Solarzelle 1" platziert (Schritt S9) und durch Verlöten mit diesem verbunden (Schritt S10). Ein erster Solarzellen-String ist nun fertiggestellt. Damit ein nächster Solarzellen-String hergestellt werden kann, wird der Solarzellen-String um einige Positionen verschoben (Schritt S11). Danach kann ein zweiter Solarzellen-String nach dem beschriebenen Verfahrens-Ablauf hergestellt werden. Die hierzu notwendigen Schritte S12 bis S21 entsprechen im Wesentlichen den vorgängig beschriebenen Schritten S1 bis S10. Zum besseren Verständnis und zur Unterscheidung sind die Solarzellen des zweiten Solarzellen-Strings mit 2, 2' und 2" bezeichnet.

Es ist eine Aufgabe der Erfindung, ein Verfahren und eine Vorrichtung zum Herstellen von Solarzellen-Strings zu schaffen, mit der Solarzellen- Strings einfach und in effizienter Art und Weise hergestellt werden können.

Diese Aufgabe wird erfindungsgemäss mit einem Verfahren zum Herstellen von Solarzellen-Strings mit den Merkmalen des Anspruchs 1 gelöst. Das Verfahren zum Herstellen von Solarzellen-Strings, die aus aneinandergereihten Solarzellen bestehen, die durch elektrisch leitfähige Leiterbänder einer ersten Länge miteinander verbunden sind oder werden, umfasst im Wesentlichen folgende Verfahrensschritte: Es werden wenigstens zwei Solarzellen durch wenigstens ein Leiterband der ersten Länge miteinander verbunden. Die Verbindung der Solarzellen erfolgt dabei derart, dass die Leiterbänder jeweils eine Sonnenseite bzw. Vorderseite einer Solarzelle mit einer Rückseite einer benachbarten Solarzelle verbinden. Die Solarzellen sind dabei jeweils in einem String-Zellenabstand voneinander beabstandet. Dieser erste Verfahrensschritt wird so lange durchgeführt, bis eine gewünschte Anzahl von Solarzellen zum Herstellen eines ersten Solarzellen-Strings elektrisch miteinander verbunden sind. In einem nächsten Verfahrensschritt wird eine weitere Solarzelle mit einer letzten Solarzelle des ersten Solarzellen-Strings durch wenigstens ein vorzugsweise gegenüber dem erwähnten Leiterband mit der ersten Länge verlängerten Leiterband verbunden, wobei die weitere Solarzelle von der letzten Solarzelle in einem grösseren als im String-Zellenabstand beabstandet ist und wobei die genannte weitere Solarzelle die erste Solarzelle für einen zweiten Solarzellen-String bildet. Das verlängerte Leiterband stellt somit gewissermassen eine Art Zwischen-Leiterband dar. Danach kann der vorerwähnte erste Verfahrensschritt zumindest teilweise wiederholt werden. Zu beachten ist herbei, dass nun nicht mehr alle Solarzellen bis zum Erreichen der gewünschten Anzahl von Solarzellen für den zweiten und die weiteren Strings angefügt werden müssen. Das Verfahren umfasst als weiteren Verfahrensschritt das Trennen des verlängerten Leiterbandes zum Abkoppeln des ersten Solarzellen-Strings.

Dadurch, dass die letzte Solarzelle des ersten Solarzellen-Strings durch wenigstens ein vorzugsweise gegenüber den Leiterbändern des ersten Solarzellen-Strings verlängertes Leiterband verbunden wird, können Solarzellen-Strings in einem kontinuierlichen Prozess gefertigt werden. Mit Ausnahme des allerersten Strings und des letzten in einem Gesamtprozess hergestellten Strings entfällt das Anbringen von speziellen Anfangs-Leiterstücken und End-Leiterstücken an die Solarzellen-Strings, wodurch der Verfahrensablauf optimiert und der Output erheblich vergrössert werden kann. Bis auf den ersten und letzten Solarzellen-String kann also eine Vielzahl von Strings in einem Gesamtprozess mit lediglich zwei unterschiedlichen Leiterband-Arten hergestellt werden. Der Automatisierungsgrad lässt sich durch dieses Verfahren nochmals erheblich erhöhen.

Wenn die Leiterbänder jeweils vorgeformt sind werden oder beim Verbindungsvorgang zweier Solarzellen derart geformt werden, dass eine Stufe zum Überbrücken des Niveauunterschieds zum Verbinden einer Sonnenseite einer Solarzelle mit einer Rückseite einer benachbarten Solarzelle entsteht, kann es vorteilhaft sein, wenn beim Trennen des verlängerten Leiterbands ein Zwischenstück mit der erwähnten Stufe herausgeschnitten wird. Vorzugsweise wird das verlängerte Leiterband derartig getrennt, dass die nach dem Trennen des verlängerten Leiterbandes verbleibenden, einander gegenüberliegenden Rest-Leiterbandabschnitte hinsichtlich Längenausdehnung einem Anfangs- oder End-Leiterstück eines Solarzellen-Strings entsprechen. Auf eine Nachbearbeitung eines derart herstellten Solarzellen-Strings kann somit verzichtet werden. Der String des verlängerten Leiterbandes kann durch einen Stanzvorgang erfolgen. Dies lässt sich mit einfachen technischen Mitteln erreichen.

In einer bevorzugten Ausführungsform erfolgt das Trennen des verlängerten Leiterbandes erst nach dem Verbinden einer zweiten Solarzelle an die weitere Solarzelle für den zweiten Solarzellen-String. Auf diese Weise kann ein sicherer und störungsfreier Prozessablauf gewährleistet werden. Das Trennen kann unmittelbar nach Anbringen dieser zweiten oder nach Anbringen einer dritten oder von weiteren Solarzellen erfolgen. Theoretisch wäre es sogar vorstellbar, zuerst einen Super-String mit einer Vielzahl von durch verlängerte Leiterbänder miteinander verbundenen Solarzellen-Strings zu produzieren und erst danach die Trennvorgänge (je nach Anzahl verlängerter Leiterbänder) vorzunehmen.

Besonders vorteilhaft kann es sein, wenn nach dem Trennen des wenigstens einen verlängerten Leiterbandes wenigstens eine Solarzelle jeweils mittels wenigstens eines Leiterbandes der ersten Länge und im String-Zellenabstand zum Bilden des zweiten Solarzellen-Strings an das bereits aufgebaute, Leiterbänder und Solarzellen aufweisende Gebilde angeführt wird.

Verfahrensmässig kann es sodann vorteilhaft sein, wenn das Trennen des verlängerten Leiterbandes simultan mit dem Ablegen eines Leiterbandes der erste Länge auf einer Solarzelle für den zweiten Solarzellen-String erfolgt.

Besonders bevorzugt ist es, wenn eine Vielzahl von Solarzellen-Strings in einem kontinuierlichen Prozess hergestellt werden, wobei ausser für den ersten Solarzellen-String und einen letzten Solarzellen-String des gesamten Herstellungsprozesses Leiterbänder mit zwei unterschiedlichen Längen (d.h. Leiterbänder mit einer ersten Länge, die an den gewünschten Zellenabstand angepasst ist einerseits und verlängerte Leiterbänder der beschriebenen Art andererseits) verwendet werden.

Ein weiterer Aspekt der Erfindung betrifft eine Vorrichtung zum Herstellen von Solarzellen-Strings mit welchen das vorgängig beschriebene Verfahren durchführbar ist. Die Vorrichtung umfasst ein Modul zum Verbinden zweier Solarzellen durch wenigstens ein Leiterband. Das Modul umfasst eine Fördereinrichtung zum Fördern von Solarzellen, eine Ablege-Einrichtung zum Ablegen von Solarzellen auf die Fördereinrichtung, eine Positionier-Einrichtung zum Positionieren eines vorderen Bereiches wenigstens eines Leiterbandes auf einer auf der Fördereinrichtung abgelegten Solarzelle, wobei mit der Positionier-Einrichtung Leiterbänder unterschiedlicher Länge ablegbar sind, und eine Trenn-Station zum Trennen des wenigstens einen Leiterbandes zwischen zwei miteinander verbundenen, mittels der Fördereinrichtung geförderten Solarzellen.

Die Trenn-Station kann derart ausgestaltet sein, dass beim Trennen eines Leiterbandes ein überschüssiges Leiterband-Stück entfernbar ist. Dabei wird bevorzugt das eingangs erwähnte, verlängerte Leiterband, welches die letzte Solarzelle eines Solarzellen-Strings mit einer ersten Solarzelle eines nachfolgenden Solarzellen-Strings verbindet, getrennt.

Die Trennstation kann zwei in Bezug auf die Förderrichtung oder durch die Aneinanderreihung der Solarzellen vorgegebene Längsrichtung nebeneinander angeordnete Schneid- oder Abscherelemente aufweisen. Die Schneid- oder Abscherelemente können fix oder in Richtung der Fördereinrichtung zum Ausführen eines Schneid- oder Stanzvorganges bewegbar in der Vorrichtung montiert sein.

Das Verbindungs-Modul kann weiter eine Kontaktierungs-Einrichtung zum Erstellen eines elektrischen Kontakts zwischen Solarzelle und Leiterband aufweisen, wobei die Kontaktierungs-Einrichtung als Löt-, Schweiss-, Klebe- oder Tape-Einrichtung ausgeführt sein kann.

Weitere Einzelmerkmale und Vorteile der Erfindung ergeben sich aus der nachfolgenden Beschreibung eines Ausführungsbeispiels und aus den Zeichnungen. Es zeigen:
- Fig. 1:: eine schematische Darstellung eines Verfahrens zum Herstellen von Solarzellen-Strings gemäss dem Stand der Technik,
- Fig. 2:: das erfindungsgemässe Verfahren,
- Fig. 3:: eine perspektivische Darstellung eines Moduls zum Verbinden von Solarzellen für die Herstellung von Solarzellen-Strings, und
- Fig. 4:: eine Trenn-Station der Vorrichtung (Detail aus Fig. 3).

Fig. 2 zeigt das erfindungsgemässe Verfahren zum Herstellen von Solarzellen-Strings, aufgeteilt in einzelne Verfahrensschritte. Das Verfahren zeichnet sich dadurch aus, dass zwei oder mehrere Solarzellen 1, 1', 1" durch Leiterbänder 5 einer ersten Länge L miteinander verbunden werden. Die Länge L ist dabei abhängig vom gewünschten String-Zellenabstand s benachbarter Zellen eines Strings. Dieser Abstand wird nachfolgend auch als String-Zellenabstand bezeichnet. Anstatt wie beim in Fig. 1 dargestellten bekannten Verfahren die Solarzellen-Strings durch Bereitstellen eines Anfangs-Leiterstücks als Ausgangspunkt zum Aufbau des Strings und dem Anbringen eines End-Leiterstücks an eine letzte Solarzelle eines Gebildes mit aneinander gereihten und miteinander verbundenen Solarzellen einzeln herzustellen, wird an die letzte Solarzelle 1" des ersten Solarzellen-Strings 11 ein gegenüber dem Leiterband 5 verlängertes Leiterband 7 angebracht und der Stringaufbau wenigstens um eine weiter Solarzelle fortgesetzt. Die jeweiligen Solarzellen-Strings entstehen durch Trennen der verlängerten Leiterbänder 7. Aus Figur 2 ist erkennbar, dass der erste Solarzellen-String 11 durch Trennen des die Solarzellen 1 " und 2 verbindenden Leiterbandes 7 abgekoppelt und auf diese Weise die Herstellung des ersten Solarzellen-String 11 wenigstens vorläufig beendet wird.

Der genaue Verfahrensablauf ist wie folgt: Zunächst wird ein erster Solarzellen-String gemäss dem an sich bekannten Verfahren teilweise aufgebaut. Die in Fig. 2 mit NS1 bis NS8 bezeichneten Verfahrensschritte sind ersichtlicherweise im Wesentlichen identisch mit denjenigen aus Fig. 1 (dort Schritte S1-S8). Im Unterschied zum bekannten Verfahren, bei dem an die letzte Solarzelle ein End-Leiterband angefügt wird, wird im hier vorgestellten Verfahren ein weiteres Leiterband 7 an die mit 2" bezeichnete Solarzelle angefügt wird. Hinsichtlich Formgebung ist das Leiterelement 7 gleichartig wie die bisher eingesetzten Leiterelemente 5 ausgestaltet und weist ebenfalls eine Stufe 16 auf. Das Leiterelement 7 ist gegenüber den Leiterelementen 5 jedoch deutlich verlängert. Die Lange des verlängerten Leiterelements ist mit XL bezeichnet. und die Überlänge (XL-L) kann beispielsweise 1 cm und mehr betragen. Danach wird in einem nächsten Arbeitsschritt NS10 eine weitere Solarzelle 2 auf dem Leiterelement 7 platziert. Wie aus Fig. 2 hervorgeht, ist der Zellenabstand t zwischen den Zellen 2 und 2" deutlich grösser als der String-Zellenabstand s zwischen den Zellen 1 und 1' bzw. 1 und 1". Dann wird in an sich bekannter Art und Weise eine weitere Solarzelle 2' mittels des Leiterbands 5 angefügt. Es wird also ein Leiterelement 5 auf die Solarzelle 2 abgelegt (NS12) und darauf dann eine Solarzelle 2' platziert (Schritt NS13). Die Schritte NS12 und NS13 entsprechen ersichtlicherweise im Wesentlichen den Schritten NS2 und NS3 bzw. S2 und S3. Nachdem das so geschaffene Gebilde um eine Position verschoben wurde, wird das verlängerte Leiterband 7 mit Hilfe einer mit 8 bezeichneten Trenn-Station durchtrennt. Beim Trennungsvorgang, der in den Schritten NS14-NS15 dargestellt ist, wird ein Zwischenstück herausgeschnitten. Nach dem Trennvorgang ist der erste Solarzellen-String 11 an sich fertiggestellt. Im Schritt NS16 wird eine dritte Solarzelle 2" auf einem zweiten Leiterelement 5 abgelegt und danach um eine Position verschoben (NS17). Die Arbeitsschritte NS16 und NS17 entsprechen im Wesentlichen den Schritten NS7 und NS8. Danach werden zum Aufbau des dritten und weiterer Strings die jeweiligen Schritte wiederholt. Zum Aufbau des dritten Solarzellen-Strings wird ein verlängertes Leiterband 7 an die letzte Solarzelle 2" angefügt (NS18). Die Solarzellen 2, 2' und 2" ergeben schliesslich einen zweiten Solarzellen-String 12, der im Schritt NS19 (jedoch vor dem Trennvorgang) fertiggestellt ist. Die Solarzelle 2" bildet die letzte Solarzelle eines zweiten, mit 12 angedeuteten Solarzellen-Strings. Die Schritte NS9 bis NS16 können nun wiederholt werden. Eine mit "3" bezeichnete Solarzelle, die eine erste Solarzelle eines dritten Solarzellen-String bildet, wird im Schritt NS 19 auf dem verlängerten Leiterband 7 platziert. Die weiteren Schritte zum Aufbauen des dritten und der weiteren Strings ergeben sich aus der vorgängigen Beschreibung. Gegen Prozessende kann schliesslich an die letzte Solarzelle des letzten Strings ein (nicht dargestelltes) End-Leiterband angebracht werden.

Die vorliegend hergestellten Solarzellen-Strings bestehen beispielhaft aus drei Solarzellen. Selbstverständlich kann die Anzahl Solarzellen pro String je nach Einsatz- und Anwendungsgebiet variiert werden. Bei der Beschreibung des Verfahrens wurde der Einfachheit halber nur ein Leiterband genannt und dargestellt, das jeweils zwei benachbarte Solarzellen miteinander verbindet. Benachbarte Solarzellen werden in der Regel jedoch durch zwei, drei oder je nach Zellengrösse sogar mehreren Leiterbändern elektrisch miteinander verbunden, die bevorzugt parallel zueinander in durch die Aneinanderreihung vorgegebene Längsrichtung verlaufen. Unter dem in der Beschreibung verwendete Begriff "Leiterband" kann damit auch eine Gruppe von Leiterbändern verstanden werden.

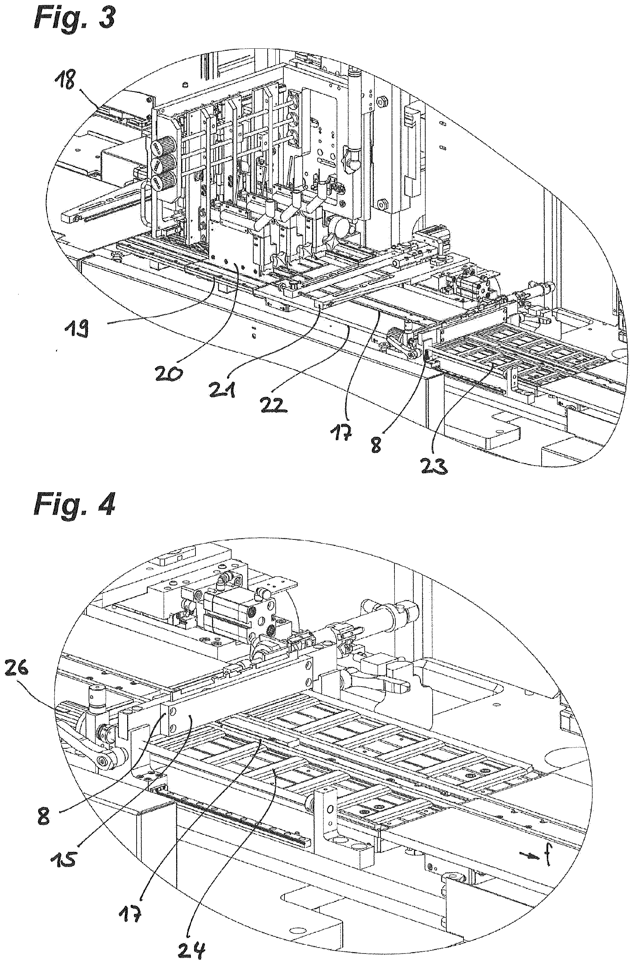

Die Leiterbänder für die gängigen Solarzellen sind zwischen 0.01 mm und 1 mm dick und 0.5 mm bis zu ca. 50 mm breit. Die Leiterbänder bestehen aus Kupferbändern, die in der Regel verzinnt (mit Lot beschichtet) oder in einzelnen Fällen versilbert sind. Sowohl die Leiterbänder 5 als auch die verlängerten Leiterbänder 7 weisen eine Stufe 16 zum Überbrücken des Niveauunterschieds zum Verbinden einer Sonnenseite einer Solarzelle mit einer Rückseite einer benachbarten Solarzelle auf. Diese Stufe kann aufgrund der Flexibilität des dünnen Leierbandes durch das Überbrücken des Niveauunterschieds zum Verbinden einer Sonnenseite einer Solarzelle mit einer Rückseite einer benachbarten Solarzelle entstehen. Die Stufe kann je nach Solarzellendicke und Zellenabstand ein mehr oder weniger kontinuierlicher Übergang sein. Selbstverständlich wäre es aber auch vorstellbar, die Leiterbänder vorzuformen und vor dem Platzieren mit einer Stufe 16 zu versehen. Beim Trennen des verlängerten Leiterbandes 7 wird ein Zwischenstück mit der Stufe 16 heraus geschnitten (siehe Schritte NS14-NS15). Die nach dem Trennen des verlängerten Leiterbandes 7 verbleibenden, einander gegenüberliegenden Rest-Leiterbandabschnitte 24, 25 entsprechen hinsichtlich Längenausdehnung einem Anfangsstück oder - abschnitt oder End-Leiterstücks eines Solarzellen-Strings (vgl. Fig. 1, worin die Anfangsstücke End-Leiterstücke mit 4, 5 bezeichnet wurden). Das Trennen des verlängerten Leiterbandes 7 erfolgt beispielsweise durch einen Stanzvorgang mittels einer Trenn-Station 8. Die Trenn-Station 8 weist zwei in Bezug auf die Förderrichtung nebeneinander angeordnete Schneid- oder Abscherelemente 13 und 14 und einen zwischen den Schneid- oder Abscherelementen 13, 14 durchführbaren Stanzkörper 15 auf. Fig. 3 zeigt eine Vorrichtung zum Herstellen von Solarzellen-Strings. Die Vorrichtung verfügt über eine als Walking-Beam ausgestaltete Fördereinrichtung 17 zum Fördern von aneinandergereihten Solarzellen. Die Förderrichtung ist mit einem Pfeil f angedeutet. In einer ersten Station werden die Solarzellen mit Hilfe einer Ablege-Einrichtung 18 auf der Fördereinrichtung platziert. In der selben Station können die Solarzellen vorgeheizt und aktiviert werden. In einer Kontaktier-Einrichtung 19 werden die Solarzellen aufgeheizt und mit den Leiterbändern durch Löten verbunden. Die Kontaktier-Einrichtung 19 umfasst hierzu beispielhaft drei Lötköpfe. Im vorliegenden Ausführungsbeispiel werden die Solarzellen jeweils über drei Leiterbänder mit den benachbarten Solarzellen verbunden. Demzufolge verfügt die Vorrichtung über jeweils drei Einheiten. Selbstverständlich lässt sich die Vorrichtung auch an andere Spezifikationen anpassen. Mit einer Positionier-Einrichtung 21 werden die erwähnten drei Leiterbänder einzeln oder gemeinsam auf der die Solarzellen fördernde Fördereinrichtung 17 abgelegt. Mit 22 ist eine Post-Heating-Zone bezeichnet, in der durch den Lötprozess verursachte Spannungen abbaubar sind. In der Trenn-Station 8 können die aneinandergereihten und durch Leiterbänder miteinander verbundenen Solarzellen voneinander getrennt werden. Die Solarzellen werden beim Passieren der Trenn-Station ebenfalls erwärmt. Ein entsprechende Post-Heating-Zone ist mit 23 bezeichnet.

Weitere konstruktive Details insbesondere der Trenn-Station 8 der Vorrichtung sind in Fig. 4 erkennbar. Die Trenn-Station verfügt über einen auf- und abbewegbaren Stanzkörper 15. Über einen Einstellmechanismus 26 mit einem Einstellrad 26 kann zum Anpassen an unterschiedliche Solarzellengrössen, Zellenabstände, Leiterbänder und/oder abzutrennende Leiterband-Zwischenstücke auf die eingewirkt Trenn-Station 8 werden. Der Stanzkörper 15 ist beispielsweise pneumatisch antreibbar. Selbstverständlich sind aber auch andere Antriebsmittel denkbar. Die Post-Heating-Zone 23 weist hintereinander angeordnete Heizkörper 24 zum Beheizen der Solarzellen auf.

## Patentansprüche

1. Verfahren zum Herstellen von Solarzellen-Strings (11, 12) enthaltend folgende Schritte:
- Verbinden wenigstens zweier Solarzellen (1, 1', 1") durch wenigstens ein Leiterband (5) einer ersten Länge (L), wobei die Solarzellen (1, 1', 1") jeweils in einem String-Zellenabstand (s) voneinander beabstandet sind, bis eine gewünschte Anzahl von Solarzellen (1, 1', 1") zum Herstellen eines ersten Solarzellen-Strings (11) miteinander verbunden ist,
- Verbinden einer weiteren Solarzelle (2) mit einer letzten Solarzelle (1 ") des ersten Solarzellen-Strings (11) durch wenigstens ein gegenüber dem erwähnten Leiterband (5) mit der ersten Länge (L) verlängertes Leiterband (7), wobei die weitere Solarzelle (2) von der letzten Solarzelle (1 ") in einem grösseren Abstand (t) als dem String-Zellenabstand (s) beabstandet ist, und wobei die weitere Solarzelle (2) die erste Solarzelle für einen zweiten Solarzellen-String (12) bildet,
- Trennen des verlängerten Leiterbandes (7) zum Abkoppeln des ersten Solarzellen-Strings (11).

2. Verfahren nach Anspruch 1, **dadurch gekennzeichnet, dass** beim Trennen des verlängerten Leiterbandes (7) ein Zwischenstück heraus geschnitten wird.

3. Verfahren nach Anspruch 1 oder 2, **dadurch gekennzeichnet, dass** das verlängerte Leiterband (7) derart getrennt wird, dass die nach dem Trennen des verlängerten Leiterbandes (7) verbleibenden, einander gegenüberliegenden Rest-Leiterbandabschnitte (24, 25) hinsichtlich Längenausdehnung einem Anfangs- oder End-Leiterstücks (4) eines Solarzellen-Strings (11) entsprechen.

4. Verfahren nach einem der Ansprüche 1 bis 3, **dadurch gekennzeichnet, dass** das Trennen des verlängerten Leiterbandes (7) durch einen Stanzvorgang erfolgt.

5. Verfahren nach einem der Ansprüche 1 bis 4, **dadurch gekennzeichnet, dass** das Trennen des verlängerten Leiterbandes (7) erst nach dem Verbinden einer zweiten Solarzelle (2) an die weitere Solarzelle (1 ") für den zweiten Solarzellen-String (12) erfolgt.

6. Verfahren nach einem der Ansprüche 1 bis 5, **dadurch gekennzeichnet, dass** nach dem Trennen des verlängerten Leiterbandes (7) wenigstens eine Solarzelle (2') jeweils mittels wenigstens eines Leiterbandes (5) der ersten Länge (L) und im String-Zellenabstand (s) zum Bilden des zweiten Solarzellen-Strings (12) angefügt wird.

7. Verfahren nach einem der Ansprüche 1 bis 6, **dadurch gekennzeichnet, dass** das Trennen des verlängerten Leiterbandes (7) simultan mit dem Ablegen eines Leiterbandes (5) der ersten Länge (L) auf eine Solarzelle (2', 2") für den zweiten Solarzellen-String (12) erfolgt.

8. Verfahren nach einem der Ansprüche 1 bis 7, **dadurch gekennzeichnet, dass** eine Vielzahl von Solarzellen-Strings (11, 12) in einem kontinuierlichen Prozess hergestellt werden, wobei ausser für einen ersten Solarzellen-String (11) und einen letzten Solarzellen-String des Prozesses Leiterbänder (5, 7) mit zwei unterschiedlichen Längen verwendet werden.

9. Vorrichtung zum Herstellen von Solarzellen-Strings (11, 12) und insbesondere zur Durchführung des Verfahrens nach einem der Ansprüche 1 bis 8, mit einem Modul zum Verbinden zweier Solarzellen (1, 1', 1", 2, 2', 2") durch wenigstens ein Leiterband (5), wobei das Modul umfasst:
- eine Fördereinrichtung (17) zum Förden von Solarzellen (1, 1', 1", 2, 2', 2", 3)
- eine Ablege-Einrichtung (18) zum Ablegen von Solarzellen auf der Fördereinrichtung (17),
- eine Positionier-Einrichtung (21) zum Positionieren eines vorderen Bereichs wenigstens eines Leiterbandes (5, 7) auf einer auf der Fördereinrichtung (17) abgelegten Solarzelle, wobei mit der Positionier-Einrichtung (21) Leiterbänder (5, 7) unterschiedlicher Länge ablegbar sind,
- eine Trenn-Station (8) zum Trennen eines Leiterbandes (7) zwischen zwei miteinander verbundenen, mittels der Fördereinrichtung (17) geförderten Solarzellen (1, 1', 1 ", 2, 2', 2", 3).

10. Vorrichtung nach Anspruch 9, **dadurch gekennzeichnet, dass** die Trenn-Station (8) derart ausgestaltet ist, dass beim Trennen des Leiterbandes (7) ein überschüssiges Leiterband-Stück entfernbar ist.

11. Vorrichtung nach Anspruch 9 oder 10, **dadurch gekennzeichnet, dass** die Trenn-Station (8) zwei in Bezug auf die Förderrichtung nebeneinander angeordnete Schneid- oder Abscherelemente (13, 14) aufweist.

12. Vorrichtung nach einem der Ansprüche 9 bis 11, **dadurch gekennzeichnet, dass** die Trenn-Station (8) einen zwischen den Schneid- oder Abscherelementen (13, 14) durchführbaren Stanzkörper (15) aufweist.

13. Vorrichtung nach einem der Ansprüche 9 bis 12, **dadurch gekennzeichnet, dass** das Verbindungs-Modul eine Kontaktierungs-Einrichtung (19) zum Erstellen eines elektrischen Kontakts zwischen Solarzelle und Leiterband (5) aufweist, wobei die Kontaktierungs-Einrichtung als Löt-, Schweiss-, Klebe- oder Tape-Einrichtung ausgeführt ist.

## Claims

1. A method for producing solar cell strings (11, 12) comprising the following steps:
- connecting at least two solar cells (1, 1', 1") using at least one conductor strip (5) of a first length (L), wherein the solar cells (1, 1', 1") are each spaced apart from one another at a string cell distance (s) until a desired number of solar cells (1, 1', 1") for producing a first solar cell string (11) are connected to one another;
- connecting an additional solar cell (2) to a last solar cell (1") of the first solar cell string (11) using at least one conductor band (7) that is longer compared to the aforesaid conductor band (5) with the first length (L), wherein the additional solar cell (2) is spaced apart from the last solar cell (1") at a greater distance (t) than the string cell distance (s), and wherein the additional solar cell (2) forms the first solar cell for a second solar cell string (12);
- separating the longer conductor band (7) for decoupling the first solar cell string (11).

2. The method according to claim 1, **characterized in that** an intermediate piece is cut out when the longer conductor band (7) is separated.

3. The method according to claim 1 or 2, **characterized in that** the longer conductor band (7) is separated such that the mutually opposing conductor band segments (24, 25) remaining after the separation of the longer conductor band (7) correspond in terms of their longitudinal extension to a start or end conductor piece (4) of a solar cell string (11).

4. The method according to any of claims 1 through 3, **characterized in that** the longer conductor band (7) is separated using a punch process.

5. The method according to any of claims 1 through 4, **characterized in that** the longer conductor band (7) is not separated until after the second solar cell (2) has been connected to the additional solar cell (1") for the second solar cell string (12).

6. The method according to any of claims 1 through 5, **characterized in that**, after the separation of the longer conductor band (7), at least one solar cell (2') is added by means of at least one conductor band (5) of the first length (L) and in the string cell distance (s) for forming the second solar cell string (12).

7. The method according to any of claims 1 through 6, **characterized in that** the longer conductor band (7) is separated simultaneously with the removal of a conductor band (5) of the first length (L) to a solar cell (2', 2") for the second solar cell string (12).

8. The method according to any of claims 1 through 7, **characterized in that** a plurality of solar cell strings (11, 12) are produced in a continuous process, wherein, except for a first solar cell string (11) and a last solar cell string of the process, conductor bands (5, 7) with two different lengths are used.

9. A device for producing solar cell strings (11, 12) and in particular for executing the method according to any of claims 1 through 8, having a module for connecting two solar cells (1, 1', 1", 2, 2', 2") using at least one conductor band (5), wherein the module comprises:
- a conveying device (17) for conveying solar cells (1, 1', 1", 2, 2', 2", 3);
- a removing device (18) for removing solar cells on the conveying device (17);
- a positioning device (21) for positioning a front area of at least one conductor band (5, 7) on a solar cell placed on the conveying device (17), wherein conductor bands (5, 7) of different length may be removed with the positioning device (21);
- a separating station (8) for separating a conductor band (7) between two solar cells (1, 1', 1", 2, 2', 2", 3) that are connected to one another and conveyed by mean of the conveying device (17).

10. The device according to claim 9, **characterized in that** the separating station (8) is embodied such that an excess conductor band piece may be removed when the conductor band (7) is separated.

11. The device according to claim 9 or 10, **characterized in that** the separating station (8) has two cutting or shearing elements (13, 14) arranged adjacent to one another with respect to the conveying device.

12. The device according to any of claims 9 through 11, **characterized in that** the separating station (8) has a punch body (15) that may be executed between the cutting or shearing elements (13, 14).

13. The device according to any of claims 9 through 12, **characterized in that** the connecting module has a contacting device (19) for establishing an electrical contact between solar cell and conductor band (5), wherein the contacting device is embodied as a soldering, welding, gluing, or taping device.

## Revendications

1. Procédé servant à fabriquer des chaînes de cellules solaires (11, 12), contenant des étapes qui suivent :
- l'assemblage au moins de deux cellules solaires (1, 1', 1") par au moins une bande conductrice (5) d'une première longueur (L), dans lequel les cellules solaires (1, 1', 1") sont espacées les unes des autres respectivement à une distance entre cellules de chaîne (s) jusqu'à ce qu'un nombre souhaité de cellules solaires (1, 1', 1") soient assemblées afin de fabriquer une première chaîne de cellulaires solaires (11),
- l'assemblage d'une autre cellule solaire (2) à une dernière cellule solaire (1") de la première chaîne de cellules solaires (11) par au moins une bande conductrice (7) allongée par rapport à la bande conductrice (5) mentionnée présentant la première longueur (L), dans lequel l'autre cellule solaire (2) est espacée de la dernière cellule solaire (1") d'un espacement (t) plus grand que l'espacement entre des cellules de chaîne (s) et dans lequel l'autre cellule solaire (2) forme la première cellule solaire pour une deuxième chaîne de cellules solaires (12) ;
- la séparation de la bande conductrice (7) allongée afin de découpler la première chaîne de cellules solaires (11).

2. Procédé selon la revendication 1, **caractérisé en ce qu'**une pièce intermédiaire est découpée lors de la séparation de la bande conductrice (7) allongée.

3. Procédé selon la revendication 1 ou 2, **caractérisé en ce que** la bande conductrice (7) allongée est séparée de telle manière que les sections de bande conductrice (24, 25) se faisant face les unes les autres, restant après la séparation de la bande conductrice (7) allongée correspondent, eu égard à l'extension longitudinale, à une pièce conductrice de début ou de fin (4) d'une chaîne de cellules solaires (11).

4. Procédé selon l'une quelconque des revendications 1 à 3, **caractérisé en ce que** la séparation de la bande conductrice (7) allongée est effectuée par une opération d'estampage.

5. Procédé selon l'une quelconque des revendications 1 à 4, **caractérisé en ce que** la séparation de la bande conductrice (7) allongée est effectuée seulement après l'assemblage d'une deuxième cellule solaire (2) à l'autre cellule solaire (1") pour la deuxième chaîne de cellules solaires (12).

6. Procédé selon l'une quelconque des revendications 1 à 5, **caractérisé en ce qu'**après la séparation de la bande conductrice (7) allongée, au moins une cellule solaire (2') est ajoutée respectivement au moyen au moins d'une bande conductrice (5) de la première longueur (L) et selon l'espacement entre les cellules de chaîne (s) afin de former la deuxième chaîne de cellules solaires (12).

7. Procédé selon l'une quelconque des revendications 1 à 6, **caractérisé en ce que** la séparation de la bande conductrice (7) allongée est effectuée de manière simultanée avec la pose d'une bande conductrice (5) de la première longueur (L) sur une cellule solaire (2', 2") pour la deuxième chaîne de cellules solaires (12).

8. Procédé selon l'une quelconque des revendications 1 à 7, **caractérisé en ce qu'**une pluralité de chaînes de cellules solaires (11, 12) sont fabriquées lors d'un processus continu, dans lequel sont utilisées, hormis pour une première chaîne de cellules solaires (11) et pour une dernière chaîne de cellules solaires du processus, des bandes conductrices (5, 7) présentant deux longueurs différentes.

9. Dispositif servant à fabriquer des chaînes de cellules solaires (11, 12) et en particulier servant à mettre en oeuvre le procédé selon l'une quelconque des revendications 1 à 8, comprenant un module servant à assembler deux cellules solaires (1, 1', 1", 2, 2', 2") par au moins une bande conductrice (5), dans lequel le module comprend :
- un système de transport (17) servant à transporter des cellules solaires (1, 1', 1", 2, 2', 2", 3) ;
- un système de pose (18) servant à poser des cellules solaires sur le système de transport (17) ;
- un système de positionnement (21) servant à positionner une zone avant au moins d'une bande conductrice (5, 7) sur une cellule solaire posée sur le système de transport (17), dans lequel des bandes conductrices (5, 7) de différente longueur peuvent être posées avec le système de positionnement (21) ;
- une station de séparation (8) servant à séparer une bande conductrice (7) entre deux cellules solaires (1, 1', 1", 2, 2', 2", 3) assemblées l'une à l'autre, transportées au moyen du système de transport (17).

10. Dispositif selon la revendication 9, **caractérisé en ce que** la station de séparation (8) est configurée de telle manière qu'une pièce de bande conductrice excédentaire peut être retirée lors de la séparation de la bande conductrice (7).

11. Dispositif selon la revendication 9 ou 10, **caractérisé en ce que** la station de séparation (8) présente deux éléments de découpage ou cisaillage (13, 14) disposés l'un à côté de l'autre par rapport à la direction de transport.

12. Dispositif selon l'une quelconque des revendications 9 à 11, **caractérisé en ce que** la station de séparation (8) présente un corps d'estampage (15) pouvant être guidé entre les éléments de découpage ou de cisaillage (13, 14).

13. Dispositif selon l'une quelconque des revendications 9 à 12, **caractérisé en ce que** le module d'assemblage présente un système de mise en contact (19) servant à établir un contact électrique entre une cellule solaire et une bande conductrice (5), dans lequel le système de mise en contact est réalisé sous la forme d'un système de brasage, de soudage, de collage ou à bande.
